# EUROPÄISCHE PATENTSCHRIFT

(11) **EP 2 304 816 B1**
(45) Veröffentlichungstag und Bekanntmachung des Hinweises auf die Patenterteilung: **09.08.2017**
(21) Anmeldenummer: 09771995.9
(22) Anmeldetag: 17.06.2009
(51) Int. Cl.: H01L 33/62, H01L 33/38

(54) **ELEKTROLUMINESZIERENDE VORRICHTUNG UND VERFAHREN ZUR HERSTELLUNG EINER ELEKTROLUMINESZIERENDEN VORRICHTUNG**
ELECTROLUMINESCENT DEVICE AND METHOD FOR PRODUCING AN ELECTROLUMINESCENT DEVICE
DISPOSITIF ÉLECTROLUMINESCENT ET PROCÉDÉ DE PRODUCTION D'UN DISPOSITIF ÉLECTROLUMINESCENT

(30) Priorität: 30.06.2008 DE 102008030821
(43) Veröffentlichungstag der Anmeldung: 06.04.2011
(73) Patentinhaber: OSRAM Opto Semiconductors GmbH, 93055 Regensburg (DE)
(72) Erfinder: HERRMANN, Siegfried, 94362 Neukirchen (DE)
(74) Vertreter: Epping - Hermann - Fischer
(86) Internationale Anmeldenummer: PCT/DE2009/000859
(87) Internationale Veröffentlichungsnummer: WO 2010/000225

(56) Entgegenhaltungen:
- WO-A-01/41223
- WO-A-2006/128446
- WO-A1-2008/056813
- JP-A- 2003 133 589
- JP-A- 2003 264 331
- JP-A- 2005 012 092
- US-A1- 2007 145 389
- US-A1- 2007 228 388
- CHITNIS A ET AL: "SUBMILLIWATT OPERATION OF ALLNGAN BASED MULTIFINGER-DESIGN 315 NM LIGHT EMITTING DIODE (LED) OVER SAPPHIRE SUBSTRATE" JAPANESE JOURNAL OF APPLIED PHYSICS, JAPAN SOCIETY OF APPLIED PHYSICS, TOKYO,JP, Bd. 41, Nr. 3B, PART 02, 15. März 2002 (2002-03-15), Seiten L320-L322, XP001186605 ISSN: 0021-4922

## Beschreibung

Die vorliegende Erfindung betrifft eine elektrolumineszierende Vorrichtung und Verfahren zur Herstellung einer elektrolumineszierenden Vorrichtung.

Bei einem herkömmlichen Leuchtdiodenchip wird auf der Strahlungsaustrittsfläche eine elektrisch leitfähige Kontaktstruktur aufgebracht. Diese Kontaktstruktur wird üblicherweise so ausgebildet, dass einerseits viel Licht aus der Oberfläche des Leuchtdiodenchips austreten kann, sodass die Abschattung durch die Kontaktstruktur möglichst gering ist. Andererseits soll in Halbleitern mit relativ geringer Querleitfähigkeit, wie zum Beispiel Nitridhalbleiterverbindungen, die Stromdichte möglichst homogen über die Oberfläche des Leuchtdiodenchips verteilt werden. Folglich können inhomogene elektrische Felder, die zum Beispiel in der Nähe eines Bondpads entstehen können und zu inhomogenen Stromdichteverteilungen führen, vermieden werden.

Bei Lumineszenzdioden, die eine Kantenlänge von weniger als ungefähr 300 *µ*m aufweisen, kann mit einem zentral auf der Strahlungsauskoppelfläche angeordneten Bondpad eine vergleichsweise homogene Stromverteilung im Diodenchip erreicht werden. Allerdings bewirkt der über die Oberfläche herausragende Bonddraht eine Abschattung der Strahlungsaustrittsfläche beziehungsweise eine Reduzierung des ausgekoppelten Strahlungsanteils. Bei großflächigen Lumineszenzdiodenchips, die zum Beispiel eine Kantenlänge von bis zu 1 mm aufweisen, kann diese Art der Kontaktierung zu einer inhomogenen Bestromung führen.

Zur Erhöhung des ausgekoppelten Strahlungsanteils ist in der DE 102005025416 A1 beschrieben, bei einem Lumineszenzdiodenchip das Bondpad in einem Randbereich der Strahlungsaustrittsfläche anzuordnen.

Aus der Druckschrift JP 2005-012092 A ist ein Lumineszenzdiodenchip bekannt, der auf einer Strahlungsaustrittsfläche mehrere zur Stromaufweitung vorgesehene Kontaktstege aufweist, wobei eine Kontaktstruktur außerhalb der Strahlungsaustrittsfläche angeordnet und mit den Kontaktstegen elektrisch leitend verbunden ist.

Die Druckschrift WO 2008/056813 A1 offenbart ein Licht emittierendes Bauelement mit einem Gehäuse mit mehreren voneinander getrennten Gehäuseelektroden und ein Herstellungsverfahren hierfür.

Aufgabe der Erfindung ist es nun, eine elektrolumineszierende Vorrichtung zu schaffen beziehungsweise ein Verfahren zur Herstellung einer elektrolumineszierenden Vorrichtung anzugeben, bei dem die Strahlungsabgabe weiter erhöht ist.

Diese Aufgabe wird durch eine elektrolumineszierende Vorrichtung gemäß Anspruch 1 und ein Verfahren gemäß Anspruch 14 gelöst. Diese elektrolumineszierende Vorrichtung umfasst eine Strahlungsaustrittsfläche, mehrere zur Stromaufweitung vorgesehene Kontaktstege, die auf der Strahlungsaustrittsfläche angeordnet sind, und eine Kontaktstruktur, die außerhalb der Strahlungsaustrittsfläche angeordnet ist und mit den Kontaktstegen elektrisch leitend verbunden ist.

Bei einer Weiterbildung erfolgt die Stromaufweitung auf einem isolierenden Steg, der außerhalb der Strahlungsaustrittsfläche angeordnet ist. Folglich wird Abschattung vermieden und die notwendige Fläche der Stromverteilungspfade, beispielsweise auf einem Lumineszenzdiodenchip, kann signifikant, beispielsweise um bis zu 30 % reduziert werden. Dies erlaubt einen einfachen Aufbau einer elektrolumineszierenden Vorrichtung, bei dem beispielsweise keine besonderen Maßnahmen zur Vermeidung der Lichtentstehung direkt unter einem Kontakt getroffen werden müssen.

Vorzugsweise weist der isolierende Steg, der außerhalb der Strahlungsaustrittsfläche angeordnet ist, eine Höhe auf, die sich von der Ebene der Strahlungsaustrittsfläche nur geringfügig oder gar nicht unterscheidet, um eine einfache Kontaktierung zu ermöglichen, ohne Stufen überwinden zu müssen.

In einer weiteren Ausgestaltung ist bei der elektrolumineszierenden Vorrichtung darüber hinaus eine weitere Kontaktstruktur außerhalb der Strahlungsaustrittsfläche und zur Kontaktstruktur gegenüberliegend auf einem weiteren Steg angeordnet und mit den Kontaktstegen elektrisch leitend verbunden.

Gemäß dieser Ausführungsform erfolgt ein beidseitiger Anschluss der Stromverteilungspfade mittels der Kontaktstrukturen auf den Stegen. Aufgrund des beidseitigen Anschlusses wird der Spannungsabfall weiter reduziert, sodass die Kontaktstege auf der Strahlungsaustrittsfläche in ihrer Breite weiter reduziert werden können.

In einer weiteren Ausgestaltung ist der Steg aus einem elektrisch isolierenden Material, vorzugsweise einem Kunststoff. Als isolierendes Material eignet sich insbesondere Benzocyclobutene (BCB), das über elektrisch isolierende Eigenschaften verfügt und sich problemlos in halbleitertechnologische Fertigungsschritte integrieren lässt. Benzocyclobutene (BCB) wird beispielsweise in der mikroelektromechanischen Systemtechnologie (MEMS) eingesetzt.

In einer weiteren Ausgestaltung ist darüber hinaus eine erste Kontaktfläche vorgesehen, die mittels einer leitfähigen Fläche mit der Kontaktstruktur verbunden ist.

Die erste Kontaktfläche kann beispielsweise mit einem LED-Gehäuse einem Träger oder über Durchkontaktierungen mit einer externen Spannungsquelle verbunden werden, sodass die elektrolumineszierende Vorrichtung elektrisch kontaktiert ist. Da die Kontaktierung außerhalb des strahlungsabgebenden Bereiches erfolgt, kann eine Abschattung vermieden werden.

Bei einer weiteren vorteilhaften Ausgestaltung weist die elektrolumineszierende Vorrichtung einen Lumineszenzdiodenchip, vorzugsweise einen Dünnfilm-Lumineszenzdiodenchip auf.

Bei der Herstellung eines Dünnfilm-Lumineszenzdiodenchips wird eine funktionelle Halbleiterschichtenfolge, die insbesondere eine strahlungsemittierende aktive Schicht umfasst, zunächst epitaktisch auf einem Aufwachssubstrat aufgewachsen, anschließend ein neuer Träger auf die dem Aufwachssubstrat gegenüberliegende Oberfläche der Halbleiterschichtenfolge aufgebracht und nachfolgend das Aufwachssubstrat abgetrennt. Da insbesondere die für Nitridverbindungshalbleiter verwendeten Aufwachssubstrate, beispielsweise SiC, Saphir oder GaN vergleichsweise teuer sind, bietet dieses Verfahren insbesondere den Vorteil, dass das Aufwachssubstrat wieder verwertbar ist. Das Ablösen eines Aufwachssubstrats aus Saphir von einer Halbleiterschichtenfolge aus einem Nitridverbindungshalbleiter kann beispielsweise mit einem Lift-Off-Verfahren erfolgen.

Insbesondere kann der Lumineszenzdiodenchip eine Epitaxie-Schichtenfolge aufweisen, die auf einem III-V-Verbindungshalbleitermaterial, bevorzugt Nitridverbindungshalbleiter, aber auch Phosphid-Verbindungshalbleitermaterialien oder Arsenid-Verbindungshalbleitermaterialien, basiert.

"Auf Nitrid-Verbindungshalbleitern basierend" bedeutet im vorliegenden Zusammenhang, dass die aktive Epitaxie-Schichtenfolge oder zumindest eine Schicht davon ein Nitrid-III/V-Verbindungshalbleitermaterial, vorzugsweise AlₓGa_{y}In_{1-x-y}N umfasst, wobei 0 ≤ x ≤ 1, 0 ≤ y ≤ 1 und x + y ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₓGayIn_{1-x-y}N-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

"Auf Phosphid-Verbindungshalbleitern basierend" bedeutet in diesem Zusammenhang, dass der aktive Bereich, insbesondere der Halbleiterkörper, vorzugsweise AlₙGaₘIn₁₋ₙ₋ₘP umfasst oder daraus besteht, wobei 0 ≤ n ≤ 1, 0 ≤ m ≤ 1 und n+m ≤ 1 ist, vorzugsweise mit n ≠ 0, n ≠ 1, m ≠ 0 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

"Auf Arsenid-Verbindungshalbleitern basierend" bedeutet in diesem Zusammenhang, dass der aktive Bereich, insbesondere der Halbleiterkörper, vorzugsweise AlₙGaₘIn₁₋ₙ₋ₘAs umfasst oder daraus besteht, wobei 0 ≤ n ≤ 1, 0 ≤ m ≤ 1 und n+m ≤ 1 ist, vorzugsweise mit n ≠ 0, n ≠ 1, m ≠ 0 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

In einer weiteren Ausgestaltung ist bei der elektrolumineszierenden Vorrichtung Indiumzinnoxid als Material für die Kontaktstege vorgesehen.

Gemäß dieser Ausführungsform, die sich insbesondere für kleinere Chips, das heißt für Chips mit einer Seitenlänge von 200 µm oder weniger, eignet, ein optisch transparentes, elektrisch leitendes Material für die Stromaufweitung auf der Strahlaustrittsfläche verwendet. Folglich werden metallische Kontakte vollständig eliminiert. Demgemäß wird die Strahlungsausbeute weiter erhöht.

Die oben genannte Aufgabe wird bei einem zweiten Aspekt durch ein Verfahren zur Herstellung einer elektrolumineszierenden Vorrichtung gelöst, bei dem folgende Schritte ausgeführt werden:
- Bereitstellen eines Lumineszenzdiodenchips, der eine Strahlungsaustrittsfläche aufweist,
- Bilden mehrerer zur Stromaufweitung vorgesehene Kontaktstege, die auf der Strahlungsaustrittsfläche angeordnet werden, und
- Bilden einer Kontaktstruktur, die außerhalb der Strahlungsaustrittsfläche, bevorzugt auf einem Steg, angeordnet wird und mit den Kontaktstegen elektrisch leitend verbunden wird.

Demgemäß erfolgt die Stromaufweitung auf einem isolierenden Steg, der außerhalb der Strahlungsaustrittsfläche angeordnet wird. Folglich wird Abschattung vermieden und die notwendige Fläche der Stromverteilungspfade, beispielsweise auf einem Lumineszenzdiodenchip, kann signifikant, beispielsweise um bis zu 30 % reduziert werden. Dies erlaubt einen einfachen Aufbau einer elektrolumineszierenden Vorrichtung, bei dem beispielsweise keine besonderen Maßnahmen zur Vermeidung der Lichtentstehung direkt unter einem Kontakt getroffen werden müssen.

Vorteilhafte Weiterbildungen der Erfindung sind in den Unteransprüchen angegeben.

Die Erfindung wird nachfolgend an mehreren Ausführungsbeispielen anhand der Figuren näher erläutert. funktions- beziehungsweise wirkungsgleiche Elemente, Bereiche und Strukturen tragen gleiche Bezugszeichen. Insoweit sich Elemente, Bereiche oder Strukturen in ihrer Funktion entsprechen, wird deren Beschreibung nicht notwendigerweise in jeder der folgenden Figuren wiederholt.

In den Figuren zeigen:
- Figur 1: ein erstes Ausführungsbeispiel einer elektrolumineszierenden Vorrichtung in einer schematischen Querschnittsansicht,
- Figur 2: ein zweites Ausführungsbeispiel einer elektrolumineszierenden Vorrichtung in einer schematischen Draufsicht,
- Figur 3: eine weiteres Ausführungsbeispiel einer elektrolumineszierenden Vorrichtung in einer schematischen Draufsicht,
- Figur 4: eine weitere beispielhafte Ausführungsform einer elektrolumineszierenden Vorrichtung in einer schematischen perspektivischen Seitenansicht, und
- Figur 5: eine weiteres Ausführungsbeispiel einer elektrolumineszierenden Vorrichtung in einer schematischen Draufsicht.

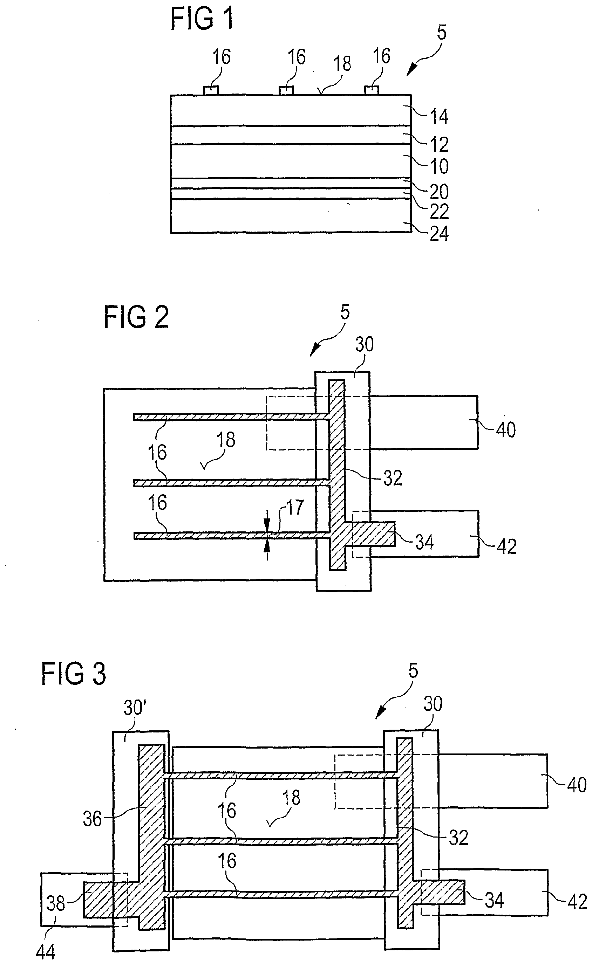

Ein erstes Ausführungsbeispiel einer elektrolumineszierenden Vorrichtung, beispielsweise mit einem Lumineszenzdiodenchip, ist in Figur 1 in einer Querschnittsansicht schematisch dargestellt. Der Lumineszenzdiodenchip 5 ist aus einer Halbleiterschichtenfolge 10, 12 und 14 aufgebaut, die beispielsweise epitaktisch hergestellt ist.

Die Halbleiterschichtenfolge enthält eine aktive Schicht 12, die vorzugsweise zur Strahlungserzeugung ausgebildet ist. Bevorzugt ist der jeweilige Halbleiterkörper als Lumineszenzdioden-Halbleiterkörper ausgeführt, um elektromagnetische Strahlung, beispielsweise Strahlung im ultravioletten, blauen oder grünen Spektralbereich, zu emittieren. Die aktive Schicht 12 ist zwischen einer n-leitenden Halbleiterschicht 14 und einer p-leitenden Halbleiterschicht 10 angeordnet.

Die aus der aktiven Schicht 12 emittierte Strahlung wird auf der Strahlungsaustrittsfläche 18 aus dem Lumineszenzdiodenchip ausgekoppelt.

Zur Stromeinprägung in die aktive Schicht 12 ist auf der Oberfläche eine Kontaktstruktur 16 vorgesehen. Die Kontaktstruktur 16 enthält vorzugsweise ein Metall oder eine Metalllegierung, insbesondere kann die Kontaktstruktur 16 aus einer strukturierten Indiumzinnoxidschicht oder einer Titan-Platin-Gold-Schichtenfolge (nicht dargestellt) gebildet sein. Zur Strukturierung können die dem Fachmann bekannten Strukturierungsverfahren, beispielsweise das lithografische Strukturieren mittels einer Maske und nachfolgenden Ätzprozessen eingesetzt werden. Die Kontaktstruktur 16 ist bevorzugt frei von Aluminium oder Silber, um unempfindlich gegenüber Elektromigration zu sein.

Bei dem Lumineszenzdiodenchip 5 handelt es sich beispielsweise um einen Dünnfilm-Lumineszenzdiodenchip. Unterhalb der p-leitenden Halbleiterschicht 10, das heißt auf der der Strahlungsaustrittsfläche 18 gegenüberliegenden Seite, kann eine Kontaktschicht 20 angeordnet sein, die einen der Kontaktstruktur 16 von der aktiven Schicht 12 aus gesehen gegenüberliegenden zweiten elektrischen Kontakt des Lumineszenzdiodenchips bildet.

Die aktive Schicht 12 des Lumineszenzdiodenchips umfasst beispielsweise InₓAl_{y}Ga_{1-x-y}N mit 0 ≤ x ≤ 1, 0 ≤ y ≤ 1 und x + y ≤ 1. Die aktive Schicht 12 kann zum Beispiel als Heterostruktur, Doppelheterostruktur oder als Quantentopfstruktur ausgebildet sein. Die Bezeichnung Quantentopfstruktur umfasst dabei jegliche Struktur, bei der Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Die Kontaktschicht 20 kann mittels einer Verbindungsschicht 22, beispielsweise einer Lotschicht, auf einem Träger 24 befestigt sein. Der Träger 24 ist beispielsweise eine Leiterplatte, insbesondere eine gedruckte Leiterplatte. Ferner kann der Träger 24 aus Keramik, beispielsweise Aluminiumnitrid, gebildet sein. Andere dem Fachmann bekannte Materialien, wie beispielsweise ein Halbleitermaterial, können ebenfalls verwendet werden.

Figur 2 zeigt ein zweites Ausführungsbeispiel einer elektrolumineszierenden Vorrichtung, die einen Lumineszenzdiodenchip 5 gemäß Figur 1 aufweist. Wie in der Draufsicht der Figur 2 zu erkennen ist, sind mehrere Kontaktstege 16 auf der Strahlungsaustrittsfläche 18 angeordnet. Der Lumineszenzdiodenchip 5 ist rechteckförmig ausgebildet, wobei die Seitenlängen des Rechtecks über einen großen Bereich variieren können. So ist es zum einen möglich, Lumineszenzdiodenchips mit einer Seitenlänge von 100 µm zu bilden. Es ist aber auch möglich, großflächige Lumineszenzdiodenchips mit 1 mm Seitenlänge oder mehr einzusetzen.

Außerhalb der Strahlungsaustrittsfläche 18, das heißt neben dem Lumineszenzdiodenchip 5, ist ein Steg 30 aus einem elektrisch isolierenden Material angeordnet. Der Steg 30 kann beispielsweise zusammen mit dem Lumineszenzdiodenchip 5 auf dem Träger 24 angebracht sein. Vorzugsweise weist der Steg 30 eine Höhe auf, die sich vom Lumineszenzdiodenchip 5 nur geringfügig oder gar nicht unterscheidet.

In Figur 2 sind beispielsweise drei Kontaktstege 16 gezeigt, die eine Breite 17 von typischerweise 20 µm aufweisen. Die Kontaktstege 16 werden mit einer Kontaktstruktur 32 verbunden, die auf der Oberfläche des Stegs 30 angeordnet ist. Dazu kann beispielsweise ein elektrisch leitendes Material verwendet werden, vorzugsweise eine Metallschicht, die auf den Steg 30 aufgedampft und geeignet strukturiert wird.

Auf der von dem Lumineszenzdiodenchip 5 abgewandten Seite des Stegs 30 befinden sich zwei Kontaktflächen 40 und 42. Die erste Kontaktfläche 42 dient dazu, eine Verbindung mit der Kontaktstruktur 32 und damit den Kontaktstegen 16 zu bilden. Dazu ist eine leitfähige Fläche 34 vorgesehen, die die Kontaktstruktur 30 mit der ersten Kontaktfläche 42 verbindet. Diese leitfähige Fläche kann ebenfalls eine geeignet strukturierte Metallschicht sein.

Es ist ebenso möglich, die Kontaktstruktur 30 und die leitfähige Fläche 34 als eine einzige Schicht herzustellen. Die zweite Kontaktfläche 40 dient dazu, einen Anschluss an die Kontaktschicht 20 herzustellen.

Wie in Figur 2 eingezeichnet ist, kann dazu die zweite Kontaktfläche unter dem Steg 30 bis zum Lumineszenzdiodenchip 5 reichen. Die erste Kontaktfläche 42 endet beispielsweise unter oder vor dem Steg 30, sodass kein Kurzschluss mit der Kontaktschicht 20 auf der Rückseite des Lumineszenzdiodenchips 5 erfolgt. Der Steg ist aus einem elektrisch isolierenden Material hergestellt, wobei vorzugsweise Kunststoff verwendet wird. In der Technologie der mikroelektromechanischen Systeme (MEMS) hat sich das Polymer Benzocyclobutene (BCB) als gut verarbeitbar herausgestellt.

Um die Strahlungsaustrittsfläche 18 nur geringfügig durch die Kontaktstege 16 abzuschatten, ist es beispielsweise möglich, eine transparente Schicht für die Kontaktstege 16 aufzubringen. Dazu kann beispielsweise Indiumzinnoxid verwendet werden.

Unter Bezugnahme auf Figur 3 wird im Folgenden ein drittes Ausführungsbeispiel einer elektrolumineszierenden Vorrichtung gezeigt. Dieses Ausführungsbeispiel unterscheidet sich von dem gemäß Figur 2 dadurch, dass die Kontaktstege nunmehr über die gesamte Strahlungsaustrittsfläche als parallele Linien ausgebildet sind. Auf der der ersten Kontaktstruktur 32 gegenüberliegenden Seite ist eine weitere Kontaktstruktur 36 angeordnet, die mit den Kontaktstegen 16 elektrisch leitend verbunden ist.

Die weitere Kontaktstruktur 36 kann ebenso auf einem weiteren Steg 30' angeordnet sein, der wie der Steg 30 aus isolierendem Kunststoffmaterial besteht. Die weitere Kontaktstruktur 36 ist mittels einer weiteren elektrisch leitfähigen Fläche 38 mit einer dritten Kontaktfläche 44 verbunden.

Da nunmehr die zur Stromaufweitung eingeprägte Spannung auf der Strahlungsaustrittsfläche 18 von beiden Seiten zugeführt werden kann, das heißt über die erste Kontaktfläche 42 und die dritte Kontaktfläche 44, tritt nur ein geringer Spannungsabfall über die Strahlungsaustrittsfläche 18 auf. Die Ausführungsform gemäß Figur 3 eignet sich sowohl für sehr dünne Kontaktstege 16 als auch für großflächige Strahlungsaustrittsflächen 18.

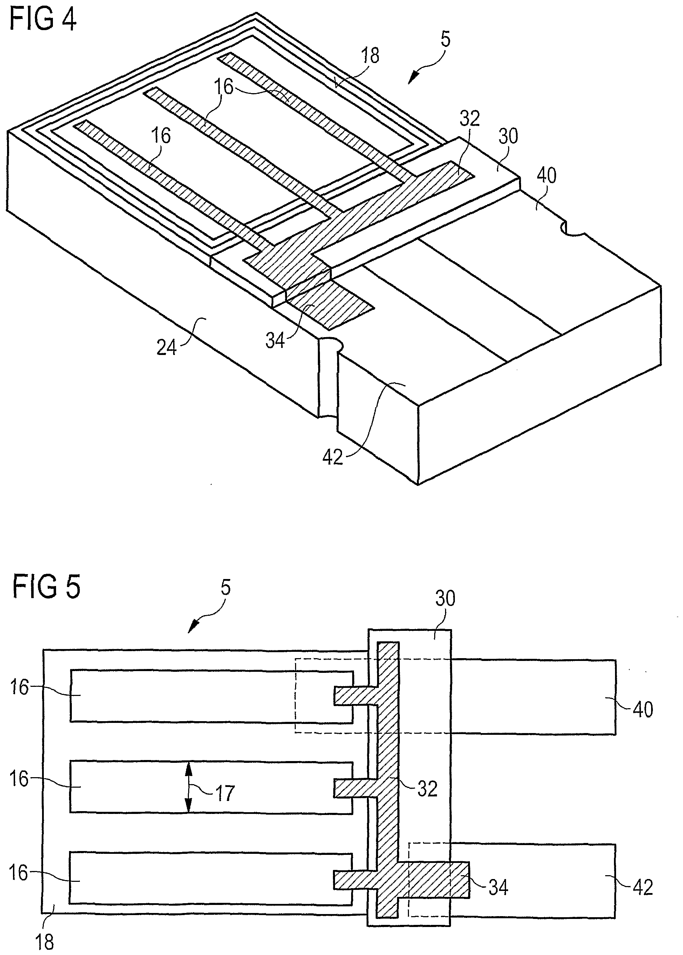

Unter Bezugnahme auf Figur 4 wird ein weiteres Ausführungsbeispiel einer elektrolumineszierenden Vorrichtung in einer schematischen Seitenansicht gezeigt. Um eine elektrolumineszierende Vorrichtung herzustellen, kann beispielsweise in einem ersten Schritt der Lumineszenzdiodenchip 5 bereitgestellt werden. Dieser wird auf dem Träger 24 aufgebracht, wie in Figur 4 gezeigt ist. Anschließend erfolgt das Aufbringen des Stegs 30 und das Ausbilden der Kontaktstege 16, der Kontaktstruktur 32 und der ersten leitfähigen Fläche 34, in dem beispielsweise eine Metallschicht aufgedampft und strukturiert wird. Die fertig hergestellte elektrolumineszierende Vorrichtung kann den nachfolgenden Schritten an der ersten Kontaktfläche 42 und der zweiten Kontaktfläche 40 mit externen Spannungsquellen versorgt werden, beziehungsweise in ein Gehäuse integriert werden.

Des Weiteren ist es ebenfalls möglich, noch weitere Prozessschritte auszuführen, wie beispielsweise das Aufbringen einer Konverterschicht auf die Strahlungsaustrittsfläche 18. Die Konverterschicht ist beispielsweise eine Silikonschicht, in die zumindest ein Lumineszenzkonversionsstoff eingebettet ist. Bei dem mindestens einen Lumineszenzkonversionsstoff kann es sich beispielsweise um YAG:Ce oder einen bekannten Lumineszenzkonversionsstoff handeln.

Mittels des Lumineszenzkonversionsstoffs wird beispielsweise die Wellenlänge zumindest eines Teils der aus der aktiven Schicht 12 emittierten Strahlung, die beispielsweise grünes, blaues oder ultraviolettes Licht ist, derart in einen komplementären Spektralbereich konvertiert, dass Weißlicht entsteht.

Die Verwendung einer Silikonschicht als Trägerschicht für den Lumineszenzkonversionsstoff hat den Vorteil, dass Silikon vergleichsweise unempfindlich gegen kurzwellige blaue oder ultraviolette Strahlung ist. Dies ist insbesondere vorteilhaft für auf Nitridverbindungshalbleitern basierende Lumineszenzdiodenchips, bei denen die emittierte Strahlung in der Regel zumindest einen Anteil aus dem kurzwelligen blauen oder ultravioletten Spektralbereich enthält. Alternativ kann auch ein andere transparentes organisches oder anorganisches Material als Trägerschicht für den mindestens einen Lumineszenzkonversionsstoff fungieren.

Weitere Prozess-Schritte umfassen das Aufbringen der Kontaktschicht 20 als reflektierende Kontaktschicht. Des Weiteren kann zwischen der Kontaktschicht 20 und der Verbindungsschicht 22 eine Barriereschicht angeordnet sein. Die Barriereschicht enthält beispielsweise TiWN. Durch die Barriereschicht insbesondere eine Diffusion von Material der Verbindungsschicht 22, die beispielsweise eine Lotschicht ist, in die reflektierende Kontaktschicht 20 verhindert, durch die insbesondere die Reflektion der reflektierenden Kontaktschicht 20 beeinträchtigt werden könnte. Diese Schritte sind dem kundigen Fachmann jedoch bekannt, und werden deshalb nicht ausführlich beschrieben.

Figur 5 zeigt ein weiteres Ausführungsbeispiel einer elektrolumineszierenden Vorrichtung in einer Draufsicht, die einen Lumineszenzdiodenchip 5 gemäß Figur 1 aufweist. Wie in Figur 5 zu erkennen ist, sind mehrere Kontaktstege 16 auf der Strahlungsaustrittsfläche 18 angeordnet. Der Lumineszenzdiodenchip 5 ist rechteckförmig ausgebildet, wobei die Seitenlängen des Rechtecks wiederum über einen großen Bereich variieren können. So ist es zum einen möglich, Lumineszenzdiodenchips mit einer Seitenlänge von 100 µm zu bilden. Es ist aber auch möglich, großflächige Lumineszenzdiodenchips mit 1 mm Seitenlänge oder mehr einzusetzen.

Außerhalb der Strahlungsaustrittsfläche 18, das heißt neben dem Lumineszenzdiodenchip 5, ist ein Steg 30 aus dem elektrisch isolierenden Material angeordnet, der beispielsweise zusammen mit dem Lumineszenzdiodenchip 5 auf dem Träger 24 angebracht ist.

In Figur 5 sind beispielsweise drei Kontaktstege 16 gezeigt, die eine Breite 17 von typischerweise 100 µm aufweisen. Die Kontaktstege 16 werden mit einer Kontaktstruktur 32 verbunden, die auf der Oberfläche des Stegs 30 angeordnet ist. Dazu kann beispielsweise ein elektrisch leitendes Material verwendet werden, vorzugsweise eine Metallschicht, die auf den Steg 30 aufgedampft und geeignet strukturiert wird.

Wie beim Ausführungsbeispiel gemäß Figur 2 befinden sich auf der von der Lumineszenzdiode 5 abgewandten Seite des Stegs 30 zwei Kontaktflächen 40 und 42. Die erste Kontaktfläche 42 dient dazu, eine Verbindung mit der Kontaktstruktur 32 und damit den Kontaktstegen 16 zu bilden. Dazu ist die leitfähige Fläche 34 vorgesehen, die die Kontaktstruktur 30 mit der ersten Kontaktfläche 42 verbindet. Diese leitfähige Fläche kann ebenfalls eine geeignet strukturierte Metallschicht sein.

Es ist ebenso möglich, die Kontaktstruktur 30 und die leitfähige Fläche 34 als eine einzige Schicht herzustellen. Die zweite Kontaktfläche 40 dient dazu, einen Anschluss an die Kontaktschicht 20 herzustellen.

Wie in Figur 5 eingezeichnet ist, kann dazu die zweite Kontaktfläche unter dem Steg 30 bis zum Lumineszenzdiodenchip 5 reichen. Die erste Kontaktfläche 42 endet beispielsweise unter oder vor dem Steg 30, sodass kein Kurzschluss mit der Kontaktschicht 20 auf der Rückseite des Lumineszenzdiodenchips 5 erfolgt.

Der Steg ist wiederum aus einem elektrisch isolierenden Material hergestellt, wobei vorzugsweise Kunststoff verwendet wird. In der Technologie der mikroelektromechanischen Systeme (MEMS) hat sich das Polymer Benzocyclobutene (BCB) als gut verarbeitbar herausgestellt.

Um die Strahlungsaustrittsfläche 18 nur geringfügig durch die Kontaktstege 16 abzuschatten, ist es beispielsweise möglich, eine transparente Schicht für die Kontaktstege 16 aufzubringen. Dazu kann beispielsweise Indiumzinnoxid verwendet werden. Demgemäß ist es möglich, die Kontaktstege großflächig auf der Strahlungsaustrittsfläche 18 aufzubringen, wie in Figur 5 gezeigt ist. Der Anschluss zu der Kontaktstruktur 32 kann dabei am Rand der Strahlungsaustrittsfläche 18 erfolgen,- so dass durch die elektrische Verbindung zwischen der Kontaktstruktur 32 und den Kontaktstegen 16 zu keiner oder nur zu einer geringen Abschattung führt. Es ist selbstverständlich ebenso möglich eine unterschiedliche Zahl von Kontaktstegen 16 auf der Strahlungsaustrittsfläche 18 anzubringen, wobei auch das vollflächige Bilden einer transparenten Schicht für die Kontaktstege 16 im Rahmen der Erfindung liegt.

## Patentansprüche

1. Elektrolumineszierende Vorrichtung umfassend:
- einen anorganischen Lumineszenzdiodenchip (5) mit einer Strahlungsaustrittsfläche (18),
- mehrere zur Stromaufweitung vorgesehene Kontaktstege (16), die auf der Strahlungsaustrittsfläche (18) angeordnet sind,
- eine Kontaktstruktur (32), die außerhalb der Strahlungsaustrittsfläche (18) angeordnet ist und mit den Kontaktstegen (16) elektrisch leitend verbunden ist, wobei die Kontaktstruktur (32) auf einem Steg (30) angeordnet ist, wobei der Steg (30) neben dem Lumineszenzdiodenchip (5) angeordnet ist,
- eine erste Kontaktfläche (42), die auf einer von dem Lumineszenzdiodenchip abgewandten Seite des Stegs angeordnet ist, und
- eine leitfähige Fläche (34), mittels derer die erste Kontaktfläche (42) mit der Kontaktstruktur (30) verbunden ist,
**dadurch gekennzeichnet, dass**
auf der von dem Lumineszenzdiodenchip abgewandten Seite des Stegs eine zweite Kontaktfläche (40) angeordnet ist, wobei die zweite Kontaktfläche unter dem Steg bis zum Lumineszenzdiodenchip reicht.

2. Elektrolumineszierende Vorrichtung nach Anspruch 1,
bei der der Steg (30) aus einem elektrisch isolierenden Material, bevorzugt Kunststoff, besonders bevorzugt Benzocyclobutene besteht.

3. Elektrolumineszierende Vorrichtung nach einem der vorherigen Ansprüche,
bei der eine weitere Kontaktstruktur (36) auf einem weiteren Steg (30') angeordnet ist.

4. Elektrolumineszierende Vorrichtung nach einem der vorherigen Ansprüche,
bei der die weitere Kontaktstruktur (36) außerhalb der Strahlungsaustrittsfläche (18) und zur Kontaktstruktur (30) gegenüberliegend angeordnet ist und mit den Kontaktstegen (16) elektrisch leitend verbunden ist.

5. Elektrolumineszierende Vorrichtung nach einem der vorherigen Ansprüche,
bei der eine dritte Kontaktfläche (44) vorgesehen ist, die mittels einer weiteren leitfähigen Fläche (38) mit der weiteren Kontaktstruktur (36) verbunden ist.

6. Elektrolumineszierende Vorrichtung nach einem der vorherigen Ansprüche,
bei der die Kontaktstege (16) eine Breite (17) zwischen einschließlich 10 µm und einschließlich 30 µm aufweisen.

7. Elektrolumineszierende Vorrichtung nach einem der vorherigen Ansprüche,
bei der die Kontaktstege (16) weniger als 20 % der Strahlungsaustrittsfläche (18) bedecken.

8. Elektrolumineszierende Vorrichtung nach einem der vorherigen Ansprüche,
bei der die Kontaktstege (16) eine strukturierte Indiumzinnoxidschicht sind.

9. Elektrolumineszierende Vorrichtung nach einem der vorherigen Ansprüche,
bei der der Lumineszenzdiodenchip (5) auf der der Strahlungsaustrittsfläche (18) gegenüberliegenden Seite eine Kontaktschicht (20) aufweist, die mit der zweiten Kontaktfläche (40) verbunden ist.

10. Elektrolumineszierende Vorrichtung nach einem der vorherigen Ansprüche,
bei der die erste Kontaktfläche und/oder die zweite Kontaktfläche auf einem Träger (24), vorzugsweise einer gedruckten Schaltung oder einem Keramikplättchen, aufgebracht sind.

11. Elektrolumineszierende Vorrichtung nach Anspruch 5,
bei der die erste Kontaktfläche, die zweite Kontaktfläche und die dritte Kontaktfläche auf einem Träger (24), vorzugsweise einer gedruckten Schaltung oder einem Keramikplättchen, aufgebracht sind.

12. Elektrolumineszierende Vorrichtung nach Anspruch 10 oder 11,
bei der zwischen der Kontaktschicht (20) und dem Träger (24) eine Verbindungsschicht, vorzugsweise eine Lotschicht, aufgebracht ist.

13. Elektrolumineszierende Vorrichtung nach einem der vorherigen Ansprüche,
bei der zumindest eine Seitenkante der Strahlungsaustrittsfläche (18) eine Länge von 100 µm oder mehr aufweist.

14. Verfahren zur Herstellung einer elektrolumineszierende Vorrichtung mit folgenden Schritten:
- Bereitstellen eines Lumineszenzdiodenchips (5), der eine Strahlungsaustrittsfläche (18) aufweist,
- Bilden mehrerer zur Stromaufweitung vorgesehene Kontaktstege (16), die auf der Strahlungsaustrittsfläche (18) angeordnet werden, und
- Bilden einer Kontaktstruktur (32), die außerhalb der Strahlungsaustrittsfläche (18) auf einem Steg (30) angeordnet wird und mit den Kontaktstegen (16) elektrisch leitend verbunden wird, wobei der Steg (30) neben dem Lumineszenzdiodenchip (5) angeordnet wird und eine erste Kontaktfläche (42) auf einer von dem Lumineszenzdiodenchip abgewandten Seite des Stegs angeordnet wird, wobei die erste Kontaktfläche mittels einer leitfähigen Fläche mit der Kontaktstruktur verbunden wird,
**dadurch gekennzeichnet, dass**
auf der von dem Lumineszenzdiodenchip abgewandten Seite des Stegs eine zweite Kontaktfläche (40) angeordnet wird, wobei die zweite Kontaktfläche unter dem Steg bis zum Lumineszenzdiodenchip reicht.

## Claims

1. An electroluminescent device comprising:
- an inorganic luminescence diode chip (5) having a radiation exit area (18),
- a plurality of contact webs (16) which are provided for current spreading purposes and are arranged on the radiation exit area (18),
- a contact structure (32), which is arranged outside the radiation exit area (18) and is electrically conductively connected to the contact webs (16), wherein contact structure (30) is arranged on a web (30), wherein the web (30) is arranged alongside the luminescence diode chip (5),
- a first contact area (42) arranged on a side of the web facing away from the luminescence diode chip, and
- a conductive area (34), by means of which the first contact area (42) is connected to the contact structure (30),
**characterized in that**
a second contact area (40) is arranged on a side of the web facing away from the luminescence diode chip, wherein the second contact area extends below the web as far as the luminescence diode chip.

2. The electroluminescent device as claimed in claim 1, wherein the web (30) consists of an electrically insulating material, preferably plastic, particularly preferably benzocyclobutene.

3. The electroluminescent device as claimed in the preceding claims,
wherein a further contact structure (36) is arranged on a further web (30').

4. The electroluminescent device as claimed in any of the preceding claims,
wherein the further contact structure (36) is arranged outside the radiation exit area (18) and in a manner lying opposite the contact structure (30) and is electrically conductively connected to the contact webs (16).

5. The electroluminescent device as claimed in any of the preceding claims,
wherein a third contact area (44) is provided, which is connected to the further contact structure (36) by means of a further conductive area (38).

6. The electroluminescent device as claimed in any of the preceding claims,
wherein the contact webs (16) have a width (17) of between 10 µm and 30 µm inclusive.

7. The electroluminescent device as claimed in any of the preceding claims,
wherein the contact webs (16) cover less than 20% of the radiation exit area (18).

8. The electroluminescent device as claimed in any of the preceding claims,
wherein the contact webs (16) are a patterned indium tin oxide layer.

9. The electroluminescent device as claimed in any of the preceding claims,
wherein the luminescence diode chip (5) has a contact layer (20) on the side lying opposite the radiation exit area (18), said contact layer being connected to a the second contact area (40).

10. The electroluminescent device as claimed in any of the preceding claims,
wherein the first contact area and/or second contact area are applied on a carrier (24), preferably a printed circuit or a ceramic lamina.

11. The electroluminescent device as claimed in claim 5, wherein the first contact area, the second contact area and the third contact area are applied on a carrier (24), preferably a printed circuit or a ceramic lamina.

12. The electroluminescent device as claimed in claim 11,
wherein a connecting layer, preferably a solder layer, is applied between the contact layer (20) and the carrier (24).

13. The electroluminescent device as claimed in any of the preceding claims,
wherein at least one side edge of the radiation exit area (18) has a length of 100 µm or more.

14. A method for producing an electroluminescent device comprising the following steps:
- providing a luminescence diode chip (5) having a radiation exit area (18),
- forming a plurality of contact webs (16) which are provided for current spreading purposes and are arranged on the radiation exit area (18), and
- forming a contact structure (32), which is arranged outside the radiation exit area (18) on a web (30) and is electrically conductively connected to the contact webs (16), wherein the web (30) is arranged alongside the luminescence diode chip (5) and a first contact area (42) is arranged on a side of the web that faces away from the luminescence diode chip, wherein the first contact area is connected to the contact structure by means of a conductive area, **characterized in that**
a second contact area (40) is arranged on a side of the web facing away from the luminescence diode chip, wherein the second contact area extends below the web as far as the luminescence diode chip.

## Revendications

1. Dispositif électroluminescent comprenant :
- une puce (5) anorganique à diode électroluminescente, comprenant une surface de sortie du rayonnement (18),
- plusieurs nervures de contact (16) ménagées pour la répartition du courant, lesquelles sont disposées sur la surface de sortie du rayonnement (18),
- une structure de contact (32) qui est disposée en dehors de la surface de sortie du rayonnement (18) et est reliée aux nervures de contact (16) de manière électroconductrice, la structure de contact (32) étant disposée sur une nervure (30), la nervure (30) étant disposée à côté de la puce (5) à diode électroluminescente,
- une première surface de contact (42) qui est disposée sur un côté de la nervure, détourné de la puce à diode électroluminescente, et
- une surface conductrice (34) au moyen de laquelle la première surface de contact (42) est reliée à la structure de contact (30),
**caractérisé en ce qu'**
une deuxième surface de contact (40) est disposée sur le côté de la nervure, détourné de la puce à diode électroluminescente, la deuxième surface de contact allant de dessous la nervure jusqu'à la puce à diode électroluminescente.

2. Dispositif électroluminescent selon la revendication 1, dans lequel la nervure (30) est constituée de matière électriquement isolante, de préférence de matière plastique, de manière particulièrement préférée de benzocyclobutène.

3. Dispositif électroluminescent selon l'une quelconque des revendications précédentes,
dans lequel une structure de contact supplémentaire (36) est disposée sur une nervure supplémentaire (30').

4. Dispositif électroluminescent selon l'une quelconque des revendications précédentes,
dans lequel la structure de contact supplémentaire (36) est disposée en dehors de la surface de sortie du rayonnement (18) et à l'opposé de la structure de contact (30) et est reliée aux nervures de contact (16) de manière électroconductrice.

5. Dispositif électroluminescent selon l'une quelconque des revendications précédentes,
dans lequel une troisième surface de contact (44) est ménagée, laquelle est reliée à la structure de contact supplémentaire (36) au moyen d'une surface conductrice supplémentaire (38).

6. Dispositif électroluminescent selon l'une quelconque des revendications précédentes,
dans lequel les nervures de contact (16) présentent une largeur (17) entre, y compris, 10 µm et, y compris, 30 µm.

7. Dispositif électroluminescent selon l'une quelconque des revendications précédentes,
dans lequel les nervures de contact (16) recouvrent moins de 20 % de la surface de sortie du rayonnement (18).

8. Dispositif électroluminescent selon l'une quelconque des revendications précédentes,
dans lequel les nervures de contact (16) sont une couche d'oxyde d'indium-étain.

9. Dispositif électroluminescent selon l'une quelconque des revendications précédentes,
dans lequel la puce (5) à diode électroluminescente présente sur le côté opposé à la surface de sortie du rayonnement (18) une couche de contact (20) qui est reliée à la deuxième surface de contact (40).

10. Dispositif électroluminescent selon l'une quelconque des revendications précédentes,
dans lequel la première surface de contact et/ou la deuxième surface de contact sont placées sur un support (24), de préférence un circuit imprimé ou une plaquette céramique.

11. Dispositif électroluminescent selon la revendication 5, dans lequel la première surface de contact, la deuxième surface de contact et la troisième surface de contact sont placées sur un support (24), de préférence un circuit imprimé ou une plaquette céramique.

12. Dispositif électroluminescent selon la revendication 10 ou 11,
dans lequel une couche de liaison, de préférence une couche de soudage, est placée entre la couche de contact (20) et le support (24).

13. Dispositif électroluminescent selon l'une quelconque des revendications précédentes,
dans lequel au moins une arête latérale de la surface de sortie du rayonnement (18) présente une longueur de 100 µm ou plus.

14. Procédé de fabrication d'un dispositif électroluminescent, comprenant les étapes suivantes :
- fourniture d'une puce (5) à diode électroluminescente, qui présente une surface de sortie du rayonnement (18),
- formation de plusieurs nervures de contact (16) ménagées pour la répartition du courant, lesquelles sont disposées sur la surface de sortie du rayonnement (18), et
- formation d'une structure de contact (32) qui est disposée sur une nervure (30), en dehors de la surface de sortie du rayonnement (18), et est reliée aux nervures de contact (16) de manière électroconductrice, la nervure (30) étant disposée à côté de la puce (5) à diode électroluminescente, et une première surface de contact (42) étant disposée sur un côté de la nervure, détourné de la puce à diode électroluminescente, la première surface de contact étant reliée à la structure de contact au moyen d'une surface conductrice,
**caractérisé en ce qu'**
une deuxième surface de contact (40) est disposée sur le côté de la nervure, détourné de la puce à diode électroluminescente, la deuxième surface de contact allant de dessous la nervure jusqu'à la puce à diode électroluminescente.
